(19) **Europäisches Patentamt**

**European Patent Office**

**Office européen des brevets**

(11) **EP 1 295 371 B1**

(12) **EUROPÄISCHE PATENTSCHRIFT**

(45) Veröffentlichungstag und Bekanntmachung des Hinweises auf die Patenterteilung:
**18.02.2004 Patentblatt 2004/08**

(21) Anmeldenummer: **01962743.9**

(22) Anmeldetag: **15.06.2001**

(51) Int Cl.$^7$: **H01S 5/10**

(86) Internationale Anmeldenummer:
**PCT/EP2001/006806**

(87) Internationale Veröffentlichungsnummer:
**WO 2001/097349 (20.12.2001 Gazette 2001/51)**

(54) **LASERRESONATOREN MIT MODENSELEKTIERENDEN PHASENSTRUKTUREN**

LASER RESONATORS COMPRISING MODE-SELECTIVE PHASE STRUCTURES

RESONATEURS LASER A STRUCTURES DE PHASES A SELECTION DE MODE

(84) Benannte Vertragsstaaten:
**AT BE CH CY DE DK ES FI FR GB GR IE IT LI LU MC NL PT SE TR**

(30) Priorität: **15.06.2000 DE 10029402**

(43) Veröffentlichungstag der Anmeldung:
**26.03.2003 Patentblatt 2003/13**

(73) Patentinhaber:
  • **Fraunhofer-Gesellschaft zur Förderung der angewandten Forschung e.V.**
    **80686 München (DE)**
  • **Forschungsverbund Berlin e.V.**
    **12489 Berlin (DE)**

(72) Erfinder:
  • **ZEITNER, Uwe, Detlef**
    **99423 Weimar (DE)**
  • **GÜTHER, Reiner**
    **12437 Berlin (DE)**

(74) Vertreter: **Pfenning, Meinig & Partner**
    **Mozartstrasse 17**
    **80336 München (DE)**

(56) Entgegenhaltungen:
  **DE-A- 4 322 163          US-A- 4 783 788**
  **US-A- 5 033 054          US-A- 5 173 914**
  **US-A- 5 272 711**

  • **PATENT ABSTRACTS OF JAPAN vol. 014, no. 248 (E-0933), 28. Mai 1990 (1990-05-28) -& JP 02 068975 A (SEIKO EPSON CORP), 8. März 1990 (1990-03-08)**

**Beschreibung**

Die vorliegende Erfindung bezieht sich auf einen Laserresonator für Halbleiterlaser wie sie insbesondere in der Informationstechnik und Telekommunikation sowie in der Lasermaterialbearbeitung eingesetzt werden.

Im Bereich der Informationstechnik und Telekommunikation werden Halbleiterlaser eingesetzt, um Signale beispielsweise in Glasfasern zu übertragen. Dabei ist es erforderlich, die in eine Monomode-Faser einzukoppelnde Strahlung in beugungsbegrenzte Spots zu fokussieren, um eine effiziente Einkopplung zu erzielen. Auch im Bereich der Lasermaterialbearbeitung werden energiereiche, beugungsbegrenzte Spots angestrebt, um ein hochpräzises Schneiden und Schweißen verschiedenster Materialien zu ermöglichen.

Für die Erzeugung monochromatischer Laserstrahlung mit hohen Energien mittels Halbleiterlaser existieren im Stand der Technik verschiedene Möglichkeiten. Diese lassen sich grob einteilen in Laserdiodenbarren, Laserdiodenstacks, Breitstreifenlaserdioden oder Trapez-Laser.

Bei den Laserdiodenbarren handelt es sich um eine Anzahl von einzelnen Laserdiodenstrukturen, die sich nebeneinander auf einem Halbleiter-Lasersubstrat befinden. Das Halbleitersubstrat besteht aus einer Mehrschichtanordnung unterschiedlicher Zusammensetzung, wobei in einer der Schichten die Laserstrahlung erzeugt wird. Diese Schicht wirkt gleichzeitig für das erzeugte Laserlicht als Schichtwellenleiter, der über die Schichtdicke lediglich einen einzigen vertikalen transversalen Mode führt. In der Schichtebene erfolgt im allgemeinen bei den Laserdiodenbarren keine räumliche Einschränkung des wellenleitenden Bereiches, was dazu führt, daß das erzeugte Laserlicht eines Einzelemitters in dieser Richtung stark multimodig ist. Zwischen den einzelnen Emittern eines solchen Laserdiodenbarrens existiert im allgemeinen ebenfalls keine feste Phasenbeziehung der erzeugten Laserstrahlen, so daß die Abstrahlung eines solchen Barrens über die abgestrahlte Fläche räumlich inkohärent ist. Ein einzelner Barren ist jedoch in der Lage, mehrere 10 W optischer Leistung abzustrahlen.

Um eine weitere Steigerung der optischen Leistung zu erreichen, werden mehrere Laserdiodenbarren zu sogenannten Laserdiodenstacks übereinander gestapelt, wodurch optische Gesamtleistungen im kW-Bereich erreicht werden. Daneben existiert weiterhin das Konzept der Breitstreifen-Einzellaser, wobei möglichst hohe Leistungen bis über den 10 W-Bereich hinaus mit Streifenbreiten um 200 µm erzielt werden. Die laterale Abstrahlung ist jedoch auch bei den Breitstreifenlaserdioden extrem multimodig.

Bei den sogenannten Trapezlasern wird eine monomodige Strahlung in einem schmalen Streifen eines "master oscillators" erzeugt, die dann in einen nahezu trapezförmigen und in seiner Formung optimierten "power amplifier"-Bereich eingekoppelt und dort verstärkt wird. Die damit erreichbaren Leistungen liegen um 2 W. Die für die Verstärkung zur Verfügung stehende Fläche des Laserstreifens wird dabei jedoch aus prinzipiellen Gründen nicht voll ausgenutzt.

Die Entwicklung der an F. Herrera, J.L. Verdegay, Genetic Algorithms and Soft Computing (Studies in Fuzziness and Soft Computing Vol. 8), Physica-Verlag Heidelberg, (1996) anknüpfenden Z-Laser L.A. Vainstein, Diffrakzija v othkrytich resonatorach i otkrytych bolnovodach s ploskoimi zerkalami (Russ.), Beugung in offenen Resonatoren und offenen Wellenleitern mit ebenen Spiegeln, Shurnal technitscheskoj fiziki (Journal für Technische Physik), Vol. 34, 193-204 (1964), beruht auf der Winkelselektivität bei Reflexion im Grenzbereich zur Totalreflexion. Die Leistung liegt bisher bei 500 mW und die Winkelselektivität beträgt ca. 2°. Zu diesem Selektionswinkel ergibt sich eine für beugungsbegrenzte Emission zweckmäßige Modenbreite von 35 µm. Eine zu Zwecken der Leistungserhöhung durchzuführende Vergrößerung der Streifenbreite auf beispielsweise 200 µm gestattet bei gleichbleibendem Selektionswinkel keine beugungsbegrenzte Emission.

In einem Laserresonator eines Halbleiterlasers, beispielsweise einer Laserdiode, existiert im allgemeinen ein Satz von elektromagnetischen Feldverteilungen, die sich bei ihrer Ausbreitung nach einem kompletten Umlauf im Resonator in Intensität und Phase bis auf einen konstanten Faktor $\gamma$ wieder vollständig reproduzieren und damit im Resonator stationär existieren. Diese diskreten Feldverteilungen werden Moden genannten. In einem Laser werden generell alle die Moden im Laserbetrieb anschwingen, deren Umlaufverluste V, wobei $V = 1 - \gamma^2$ gilt, kleiner sind als ein Wert $V_{max}$. bezeichnet dabei die sogenannte Laserschwelle, die in erster Linie von der Pumpanordnung und in dem aktiven Lasermaterial abhängig ist.

Schwingt ein Laser nur mit dem Mode mit den geringsten Umlaufverlusten an, so spricht man von einem monomodigen Laserbetrieb. Dieser Mode mit den geringsten Umlaufverlusten des Resonators wird auch Fundamentalmode genannt. Bei gleichzeitigem Anschwingen des Lasers mit mehreren Moden spricht man vom Multimodebetrieb. Die Umlaufverluste der einzelnen Lasermoden werden dabei durch die Resonatorgeometrie, wie beispielsweise die optischen Elemente im Resonator, dem Resonatorspiegel, die Aperturen und geometrischen Abmaße, bestimmt. Durch eine geeignete Wahl dieser Geometrie können die Umlaufverluste der einzelnen Moden gezielt beeinflußt werden.

In Halbleiterlasern, speziell in Breitstreifen-Laserdioden und Laserdiodenbarren, ist die Resonatorgeometrie jedoch durch die Breite der aktiven, wellenleitenden Schicht und die Resonatorspiegel, die von den Facetten gebildet werden, gegeben. Die relativ große Breite des aktiven Bereiches bei Halbleiterlasern im Vergleich zu seiner Länge, erlaubt es jedoch einer sehr großen Zahl von transversalen Moden einen Resonatorumlauf mit geringen Verlusten durchzuführen, so daß Halbleiterlaser im allgemeinen ohne besondere Maßnahmen im Multimodebetrieb arbeiten.

Nachteilig bei sämtlichen beschriebenen Varianten der Halbleiterlaser ist folglich entweder ihre geringe Leistung oder die räumliche Inkohärenz der erzeugten Laserstrahlung, die eine effektive Fokussierung des Lichtes in kleine Spots verhindert.

Aus der Literatur bekannt sind Verfahren zur Selektion von einzelnen longitudinalen Moden zur Frequenzstabilisierung von Halbleiterlasern beispielsweise durch das Aufbringen von sogenannten Bragg-Gittern aus periodischen Brechungsindexverteilungen entlang der Resonatorachse auf dem Laserchip. Dies ist beispielsweise aus der DE 43 22 163 A1 bekannt. Eine Selektion lateraler Lasermoden erfolgt dabei jedoch nicht, da diese Bragg-Gitter lediglich der Frequenzstabilisierung der Laser dienen.

Aufgabe der vorliegenden Erfindung ist es, einen Laserresonator für Halbleiterlaser anzugeben, mit dem sich Laserstrahlung mit lediglich einem in der Wellenleiterebene lateralen Mode oder nur wenigen lateralen Lasermoden erzeugen lassen. Weiterhin ist es Aufgabe der vorliegenden Erfindung ein Verfahren zur Herstellung eines derartigen Laserresonators anzugeben.

Diese Aufgabe wird durch den Laserresonator nach Anspruch 1 sowie das Verfahren nach Anspruch 20 gelöst. Vorteilhafte Weiterbildungen des erfindungsgemäßen Laserresonators sowie des erfindungsgemäßen Herstellungsverfahrens werden in den jeweiligen abhängigen Ansprüchen gegeben.

Nach dem Stand der Technik werden die Umlaufverluste einzelner Moden durch eine geeignete Wahl der Geometrie des Resonators beeinflußt. Dies betrifft insbesondere die Wahl der Abmaße des Resonators sowie die Wahl und Anordnung der weiteren optischen Elemente des Halbleiterlasers.

Grundlegend für die vorliegende Erfindung ist die Erkenntnis, daß sich die Ausbreitungscharakteristik einzelner lateraler Moden in der wellenleitenden Schicht dadurch beeinflussen läßt, daß als Fundamentalmode ein solcher mit stark lateral strukturierter Wellenfront/ Phase vorgesehen wird. Zwischen diesem so gestalteten Fundamentalmode und den jeweiligen Facetten sind entsprechend Anspruch 1 jeweils ein - durch spezielle Verteilung des effektiven Brechungsindex der Schicht gestaltetes phasenkonjugierendes holographisches Element angeordnet.

Genau die starke laterale Wellenfront/Phasen-Struktur des Fundamentalmodes bietet im Zusammenwirken mit den phasenkonjugierenden effektiven Brechungsindexstrukturen, die im weiteren Text mit der Abkürzung "Phasenstrukturen" aufgeführt werden, die Möglichkeit, zwischen dem Fundamentalmode und den angeregten unerwünschten Moden eine hohe Diskriminierung bezüglich der Umlaufverluste zu erreichen, so daß die letzteren Moden nicht anschwingen können.

Weiterhin kann vorteilhafterweise die Phasenstruktur, beispielsweise jeweils in den Nähen der beiden Facetten so gestaltet werden, daß sich deren Wirkung auf den Fundamentalmode gegenseitig kompensiert, so daß lediglich die Umlaufverluste aller Moden außer dem Fundamentalmode durch Beugung und Absorption extrem ansteigen. Die Umlaufverluste des Fundamentalmodes werden jedoch nicht beeinflußt. Diese Eigenschaft führt folglich dazu, daß der Fundamentalmode im Resonator mit sehr geringen Verlusten umlaufen kann. Da die Bedingung, daß sich der Einfluß der beiden Phasenstrukturen auf die Ausbreitungscharakteristik des Modes gegenseitig kompensiert, bei einer geeigneten Berechnung dieser Strukturen sehr stark von der Intensitätsverteilung des Fundamentalmodes abhängig ist, ist sie für die anderen Moden des Resonators gewöhnlich nicht erfüllt, was dann für diese Moden zu sehr hohen Umlaufverlusten führt. Steigen diese Verluste über $V_{max}$ so arbeitet der Laser folglich monomodig im Fundamentalmode.

Mit Hilfe des erfindungsgemäßen Laserresonators und der erfindungsgemäßen Phasenstrukturen kann folglich ein Halbleiterlaser hergestellt werden, der eine monochromatische Strahlung hoher Energie und hoher "Brightness", insbesondere mit großer räumlicher Kohärenz, d.h. einem kleinen Strahlqualitätsfaktor $M^2$ nahe 1, aufweist. Damit ist es möglich, diese Strahlung in beugungsbegrenzte Spots zu fokussieren und eine effiziente Einkopplung in Monomodefasern, beispielsweise in der Informationstechnik und Telekommunikation, durchzuführen. Auch die Erzeugung energiereicher, beugungsbegrenzter Spots, beispielsweise für die Lasermaterialbearbeitung, insbesondere für das hochpräzise Schneiden und Schweißen verschiedenster Materialien, ist mit Hilfe des erfindungsgemäßen Laserresonators auf einfache Weise möglich.

Die Erzeugung der notwendigen Phasenstrukturen erfolgt vorteilhafter Weise durch eine gezielte Änderung der lokalen Eigenschaften von Substrat, Superstrat (dies sind die beiden Schichten, die den Schichtwellenleiter oben und unten einschließen) und/oder der aktiven wellenleitenden Schicht. Hierzu kann der effektive Brechungsindex im Wellenleiter geändert werden, der unter anderem von der Dicke des Wellenleiters und von dem Brechungsindex des Wellenleiters selbst sowie von den Brechungsindizes seiner Nachbarschichten, dem Substrat und dem Superstrat, abhängt. Dabei beeinflußt eine aktive Zone mit beispielsweise einem "quantum well" und mit einer Dicke von 10 nm den effektiven Brechungsindex im Wellenleiter nur unwesentlich.

Der effektive Brechungsindex im Wellenleiter kann vorteilhafterweise durch eine lokal variierende Abdünnung des Wellenleiters beeinflußt und so über definierte Abdünnungen eine definierte Phasenstruktur erzeugt werden. Dann werden bei ihrer Ausbreitung durch den Wellenleiter die Moden entsprechend dieser Phasenstruktur in ihrer Ausbreitungscharakteristik beeinflußt, wobei mit geeigneten Verfahren die Modeneigenschaften, insbesondere die Umlaufverluste, entsprechend eingestellt werden können. Vorteilhaft an dem erfindungsgemäßen Laserresonator ist, daß zur Erzielung einer monomodigen Arbeitsweise keine lateralen Einschränkungen des aktiven Wellenleiterbereiches erforderlich sind. Eine Skalierung und Anwendung des Verfahrens auch im Bereich hoher Ausgangsleistungen von Halbleiterlaserdioden ist folglich möglich.

Die Herstellung der notwendigen Phasenstrukturen erfolgt beispielsweise durch Mikrostrukturierung der Dicke von Wellenleiter, Substrat oder Superstrat, beispielsweise mit herkömmlichen Lithographieverfahren, wie sie aus der Halbleiterchipfertigung bekannt sind. Die gleichzeitige Strukturierung der Halbleiterlaser ist dabei bereits im Wafermaßstab möglich. Für kleine Variationen $\Delta n$ des effektiven Brechungsindex $n$ mit $\Delta n/n < 0,1$ in den besagten Phasenkonjugierenden holographischen Elementen ist die effektive Ausdehnung dieser Elemente in Strahlausbreitungsrichtung auf $> \lambda/\Delta n$ erhöht werden, wobei $\lambda$ die Wellenlänge des zu verstärkenden Modes in Luft ist. Die optische Wirkung auf die Wellenfronten der Resonatormoden sollte dabei nicht durch die einfache optische Weglänge auf einem Weg parallel zur Resonatorachse berechnet werden, sondern mit einer wellenoptischen Strahlausbreitungsmethode, wie beispielsweise der bekannten Beam propagation method (BPM).

Innerhalb des durch die effektive Dicke $\lambda/\Delta n$ angegebenen Longitudinalbereiches liegt vorteilhafterweise eine über die besagte Wellenausbreitung berechenbare longitudinale Variation des effektiven Brechungsindexes vor.

Die Longitudinalvariation kann dabei durch ein binäres Muster von abwechselnd zwei effektiven Brechungsindizes angenähert werden, wobei die Verwendung eines binären Musters die Berechnung der Strahlausbreitung und die Herstellung des Laserresonators stark vereinfacht.

Die Berechnung der effektiven Brechungsindexverteilung der Phasenstrukturen erfolgt durch eine schrittweise Propagation der Feldverteilungen des zu verstärkenden Lasermodes durch das jeweilige Element, wobei nach jedem Schritt an den Stellen, an denen die Phasenwerte der dann aktuellen Feldverteilung kleiner als der Durchschnitt aller Phasenwerte ist, ein Bereich mit verringertem effektivem Brechungsindex angeordnet wird.

Die genannte stark laterale Modulation der Wellenfront $p(x)$ des elektrischen Feldes des Fundamentalmodes, mit der Amplitudenverteilung $A(x)$ in Richtung $x$ senkrecht zur Resonatorachse

$$U(x, z) = A(x) \cdot \exp(i \cdot p(x))$$

im Resonatorquerschnitt der effektiven Brechungsindexverteilung nahe der Lichtaustrittsfacette des Resonators ist so gestaltet, daß sie mit einer Funktion $p(x)$

mit mindesten fünf nicht identischen Wendepunkten beschrieben wird, wobei der minimale Phasenhub zwischen benachbarten Wendepunkten $0,1\,\pi$ beträgt.

Weiterhin ist es vorteilhafterweise möglich, den Weg des zu verstärkenden Lasermodes zwischen den beiden Endfacetten mit vorgelagerter effektiver Brechungsindexverteilung durch mehrere in die Fläche des Wellenleiters effektiv eingebrachte Spiegel umzulenken. Diese Spiegel können durch einen Graben mit einer Breite vom Mehrfachen der Lichtwellenlänge und hoher effektiver Brechungsindexdifferenz in Totalreflexion realisiert werden. Durch eine örtlich partielle Verhinderung der Totalreflexion durch eine örtlich variierende Grabenbreite kann eine Gaussche Apodisation der Spiegelreflexion erreicht werden.

Die effektiven Spiegel können auch aus Bragg-Gittern in Transmission oder Reflexion mit einem Einfallswinkel verschieden vom senkrechten Einfall auf die Richtung der Gitterfurchen bestehen.

Vorteilhafte Ausführungsformen des erfindungsgemäßen Laserresonators sehen als Funktion $p(x)$ der zu verstärkenden Lasermode eine nicht periodische Funktion vor. Diese kann weiterhin eine Bandbreiten begrenzte Zufallsfunktion sein, d.h. die maximal auftretenden Ortsfrequenzen $f$ der Funktion $p(x)$ sind kleiner als eine Maximalfrequenz $f_{max}$.

Zur Erzeugung der phasenkonjugierenden holographischen Elemente können die Eigenschaften sowohl der wellenleitenden Schicht als auch des Substrats oder des Superstrats örtlich variiert werden. Als Eigenschaften eignen sich dabei insbesondere die Dicke und/oder der Brechungsindex der jeweiligen Schicht. Besonders vorteilhaft ist es, wenn zur Erzeugung der phasenkonjugierenden holographischen Elemente die Dicke der wellenleitenden Schicht örtlich verringert ist.

Im folgenden sollen einige Beispiele erfindungsgemäßer Laserresonatoren sowie erfindungsgemäßer Herstellungverfahren gegeben werden.

Es zeigen

Fig. 1    den schematischen Aufbau eines Halbleiter-Laserresonators;

Fig. 2    die Verteilung der Phasenstrukturen in dem Laserresonator aus Fig. 1;

Fig. 3    den Aufbau eines erfindungsgemäßen Laserresonators;

Fig. 4    die Amplitudenverteilung und die Phasenverteilung eines zu verstärkenden Modes zwischen den beiden Phasenstrukturen;

Fig. 5    die Amplitudenverteilung und die Phasenverteilung zwischen den beiden Phasenstrukturen vor der anderen Phasenstruktur bezogen auf Fig. 4;

Fig. 6    die Struktur der abgedünnten Bereiche der Phasenstrukturen vor den beiden Endfacetten;

Fig. 7    die Intensitätsverteilung des ausgekoppelten Fundamentalmodes im Fernfeld des Lasers;

Fig. 8    ein weiterer erfindungsgemäßer Laserresonator mit integrierten Spiegeln;

Fig. 9    ein weiterer erfindungsgemäßer Laserresonator mit Bragg-Gittern als Umlenkelemente; und

Fig. 10    einen weiteren erfindungsgemäßen Laserresonator mit gekrümmten Endfacetten.

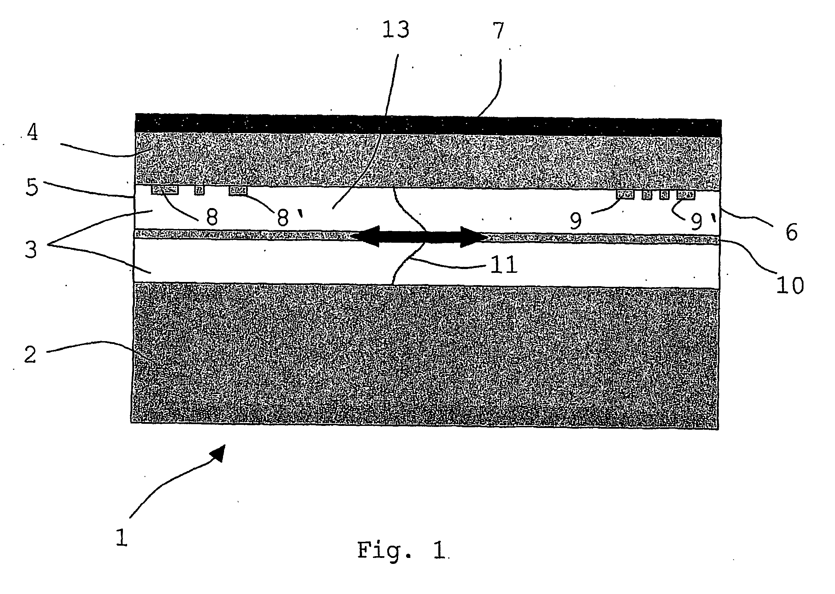

Figur 1 zeigt einen Laserresonator 1, der im wesentlichen aus drei Schichten besteht, die übereinander angeordnet sind. Diese drei Schichten sind ein Substrat 2 (untere Mantelschicht), ein Wellenleiter 3 und ein Superstrat 4 (obere Mantelschicht). Das Substrat 2 und das Superstrat 4 schließen den Wellenleiter 3 ein und erzeugen an den Grenzflächen zwischen Substrat 2 und Wellenleiter 3 sowie Wellenleiter 3 und Superstrat 4 total reflektierende Grenzflächen, so daß in der Wellenleiterschicht 3 ein Mode 11 geführt wird.

Der Wellenleiter 3 weist zwei planparallele Facetten 5 und 6 auf, wobei Facette 5 verspiegelt ist und Facette 6 eine teilverspiegelte Facette mit niedriger Reflexion darstellt. Diese beiden Facetten führen zu dem Aufbau eines Resonators für elektromagnetische Strahlung, wobei über die Facette 6 ein Teil der Resonatorstrahlung als Laserstrahl ausgekoppelt wird. Jeweils unmittelbar den beiden Facetten 5 und 6 benachbart befinden sich Bereiche 8, 8', 8" bzw. 9 bis 9", in denen der Wellenleiter 3 lokal abgedünnt ist. Durch diese Abdünnung entstehen Phasenstrukturen, die für bestimmte Moden des Laserstrahls 11 zu erhöhten Umlaufverlusten führen. Dadurch wird verhindert, daß diese Moden in dem Laserresonator anschwingen, wenn der Resonator elektrisch gepumpt wird.

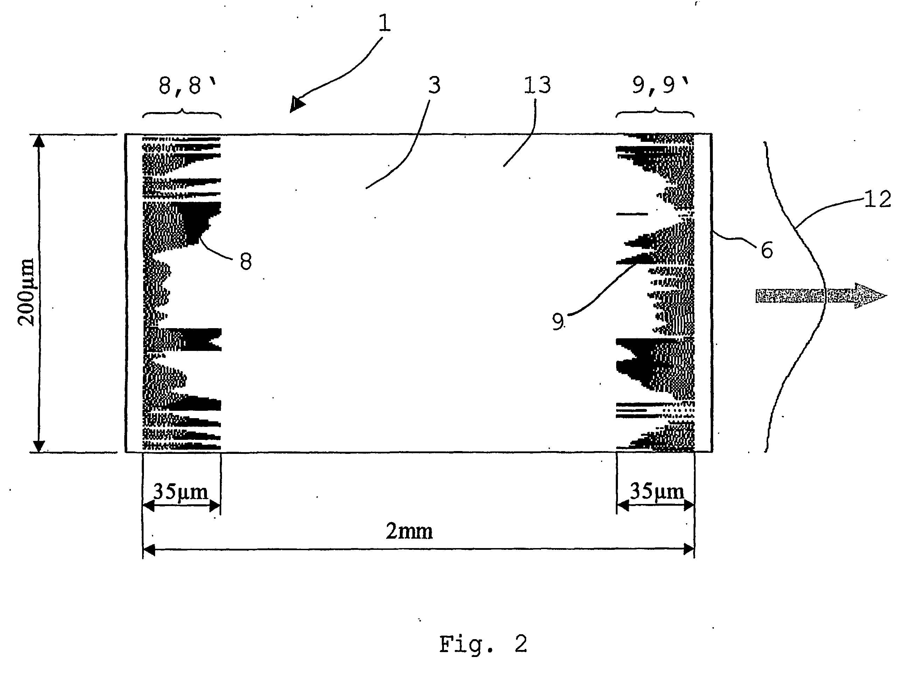

Figur 2 zeigt eine Aufsicht auf den Wellenleiter 3, wobei die lokale Abdünnung durch Grauschattierung dargestellt ist. Diese lokalen Abdünnungen, d.h. die in dem Wellenleiter 3 erzeugten Phasenstrukturen 8 und 9 sind so berechnet, daß sich ihre Wirkung auf den Fundamentalmode nahezu kompensiert, während er für alle weiteren transversalen Moden zu einer starken Erhöhung der Umlaufverluste führt.

Im vorliegenden Beispiel hat der Resonator eine Breite von 200 $\mu$m und eine Länge von 2 mm. Dieser Bereich wird elektrisch gepumpt und enthält damit die aktive Zone des Halbleiterlasers. Die Dicke des Wellenleiters, die in Figur 1 dargestellt ist, wird wie bei allen Streifen-Halbleiterlasern üblich, so gewählt, daß das elektromagnetische Feld in Richtung der Schichtdicke monomodig geführt wird. Die lokale Variation des effektiven Brechungsindexes des Wellenleiters erfolgt, wie beschrieben, durch eine gezielte lokale Variation der Dicke des Wellenleiters, wie sie durch die Schraffierungen 8 und 9 in Figur 2 dargestellt sind. Hierdurch beträgt der effektive Brechungsindex der aktiven Schicht im Bereich des nichtstrukturierten Wellenleiters $n_{1,eff}$ = 3,45, während er im Bereich der Abdünnung $n_{2,eff}$ = 3,42 beträgt.

Die Tiefe der beiden strukturierten Zonen 8 und 9 in longitudinaler Richtung, die sich direkt vor den beiden Facetten 5 und 6 befindet, beträgt jeweils maximal 35 $\mu$m.

Bei dieser beschriebenen Resonatorkonfiguration besitzt der zugehörige Fundamentalmode einen Umlaufverlust im Resonator von 2,2 %. Der zweite Mode im Resonator besitzt bereits einen Umlaufverlust von mehr als 38 % und die Verluste für alle weiteren Moden sind noch weitaus größer.

Aufgrund dieser Umlaufverlustverteilung zwischen den einzelnen Moden schwingt der beschriebene Laser lediglich im Fundamentalmode an, so daß aus dem Halbleiterlaser an der Facette 6 ein Gauß-Strahl ausgekoppelt wird, der monomodig ist und in lateraler Richtung einen Strahlradius von w = 65 $\mu$m aufweist.

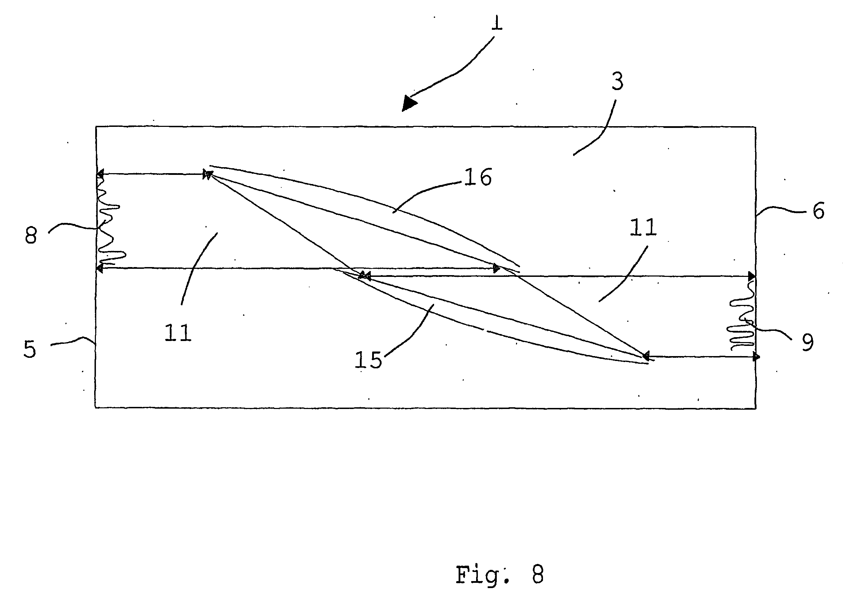

Die Grundidee des Anordnens von Phasenstrukturen in der Nähe von Facetten mit Ausbreitung von Moden durch den Wellenleiter kann auch angewendet werden, wenn zur Vergrößerung des Modenvolumens der Weg des Fundamentalmodes durch richtungsändernde Elemente der integrierten Optik, wie Spiegel, Prismen oder diffraktive (holographische) Elemente gefaltet wird. Solche Spiegel können sein: einzelne tief geätzte Gräben, Bragg-Gitter mit geraden oder gekrümmten Furchen, prismenförmig gestaltete Bereiche eines geänderten effektiven Brechungsindex oder auch totalreflektierend genutzte oder total verspiegelte Bereiche einer oder beider Facetten. Bei dem Laserresonator nach Fig. 8 sind zwei Spiegel 15, 16 in Form von geätzten Gräben in die Ausbreitungsbahn der Moden gestellt, so daß über die daran erfolgende Totalreflexion eine zweifache Spiegelung erfolgt. Die Länge des Lasers zwischen beiden Facetten beträgt 4 mm, die Strahlbreite des Modenfeldes 200 $\mu$m, die Länge der beiden spiegelnden Gräben 15, 16, 2294 $\mu$m, der Einfallswinkel des Fundamentalmodes auf die Spiegel 85° die Absenkung des effektiven Brechungsindex in den Gräben $\Delta n$ = 0,02. Die Entfernungen der Facetten 5, 6 bis zu dem jeweiligen Beginn des Spiegelpaares 15, 16 betragen 285 $\mu$m und vor beiden Facetten 5, 6 sind die wie im Hauptanspruch beschrieben aufeinander abgestimmte Gebiete 8, 9 mit variierendem effektiven Brechungsindex angeordnet. Die Modenselektivität gestattet es, in dieser Anordnung die Beugungsgrenze zu erreichen, was ohne die erfindungsgemäßen Phasenstrukturen 8, 9 als Z-Laser nicht der Fall wäre.

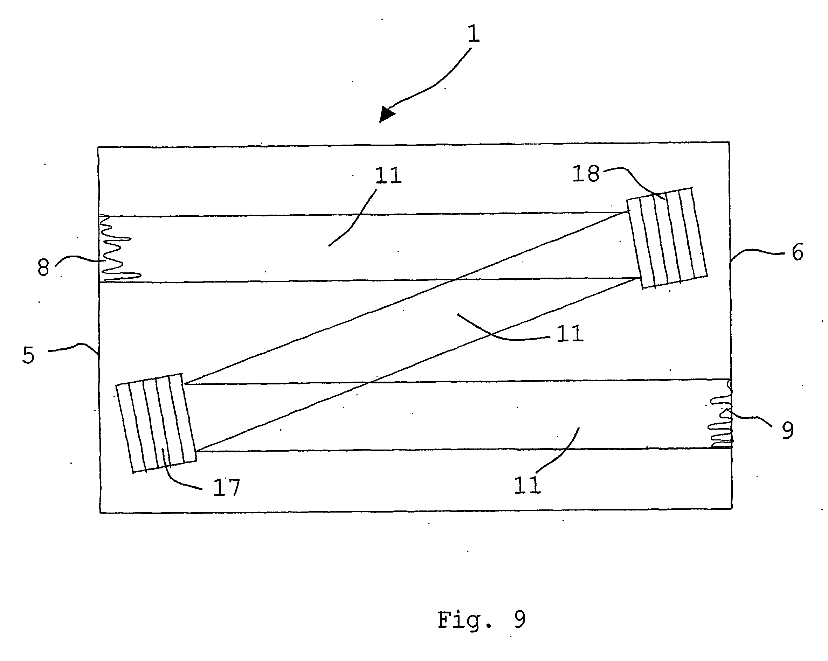

In einem weiteren Beispiel in Fig. 9 sind die beiden spiegelnden Furchen durch reflektierende Bragg-Gitter 17, 18 ersetzt und die Einfallswinkel anders gewählt.

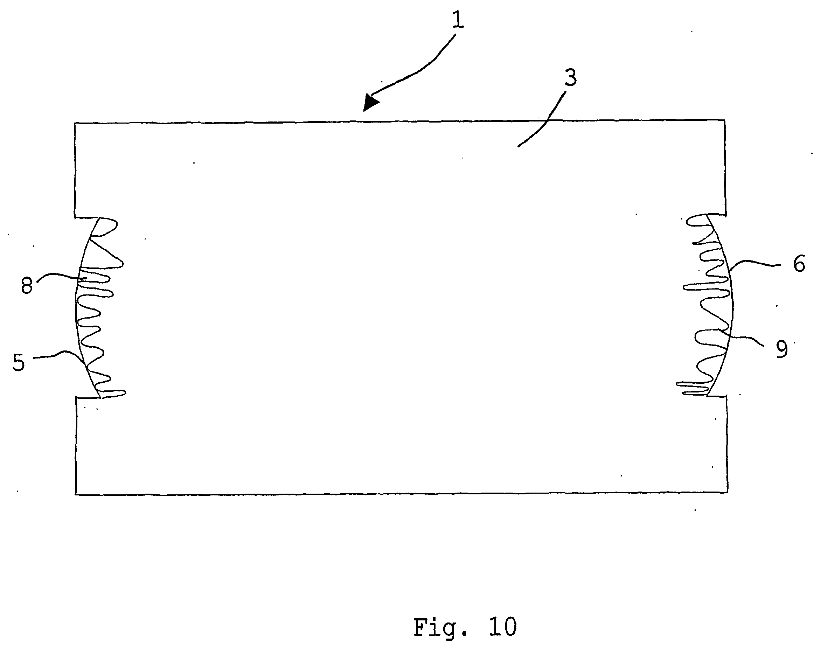

Im Beispiel gemäß Fig. 10 sind die Facetten 5, 6 des Resonators zusätzlich gekrümmt, was die Ausbreitungscharakteristik der Moden im Resonator zusätzlich zu den Phasenstrukturen 8, 9 beeinflußt. In diesem Fall hat der Fundamentalmode an den Facetten 5, 6 keine ebene Wellenfront mehr, sondern die Wellenfront besitzt die selbe Krümmung wie die jeweilige Facette 5, 6.

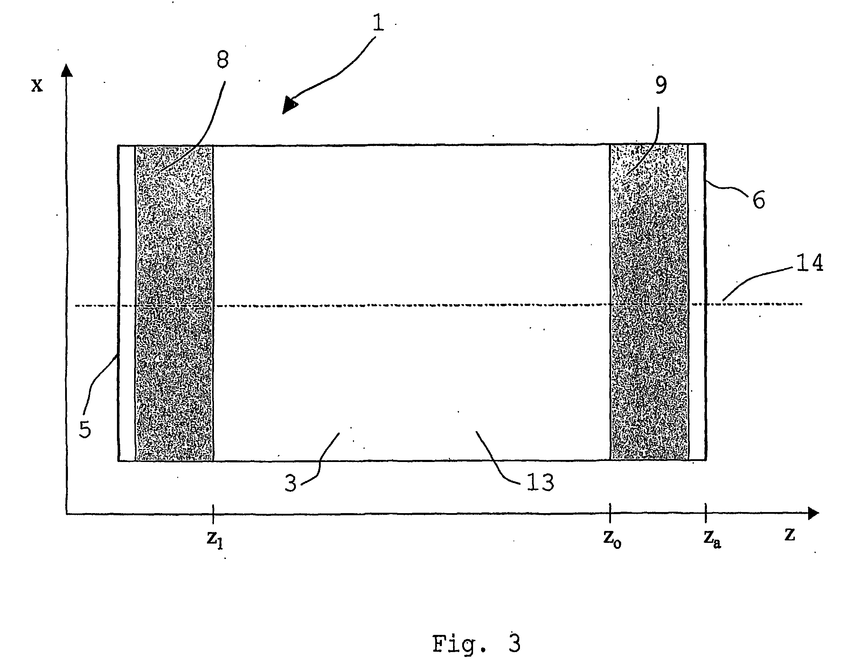

Anhand der Fign. 3 bis 6 soll nun ein erfindungsgemäßes Verfahren zur Berechnung eines erfindungsgemäßen Laserresonators erläutert werden. Dabei bezeichnen hier wie im folgenden dieselben oder ähnliche Bezugszeichen die gleichen oder ähnliche Elemente wie in den Fign. 1 und 2.

Fig. 3 zeigt dabei ein Ausführungsbeispiel eines erfindungsgemäßen Laserresonators in Aufsicht, wobei insbesondere die Bereiche der holographischen Phasenelemente 8 und 9 eingezeichnet sind. Diese sind den jeweiligen Endfacetten 5 bzw. 6 benachbart, wobei sie jedoch einen mehr oder weniger großen Abstand zu diesen Facetten einhalten können. In diesem Sinne bedeutet benachbart hier in der vorliegenden Anmeldung, daß jeder Facette 5 bzw. 6 jeweils ein Phasenelement 8 bzw. 9 zugeordnet ist. Die Phasenelemente 8 bzw. 9 können dabei jedoch längs der Resonatorlängsachse 14 an beliebiger Stelle innerhalb des Resonators angeordnet sein. Es ist demgemäß auch möglich, die Phasenelemente 8, 9 mit nur geringem Abstand voneinander im Bereich der Mitte zwischen den beiden Endfacetten 5 bzw. 6 anzuordnen. Wesentlich ist dabei jedoch immer die Zuordnung je eines Phasenelementes 8 bzw. 9 zu einer Endfacette 5 bzw. 6, wobei zwischen den beiden Phasenelementen 8 und 9 ein innerer Resonatorbereich 13 verbleibt.

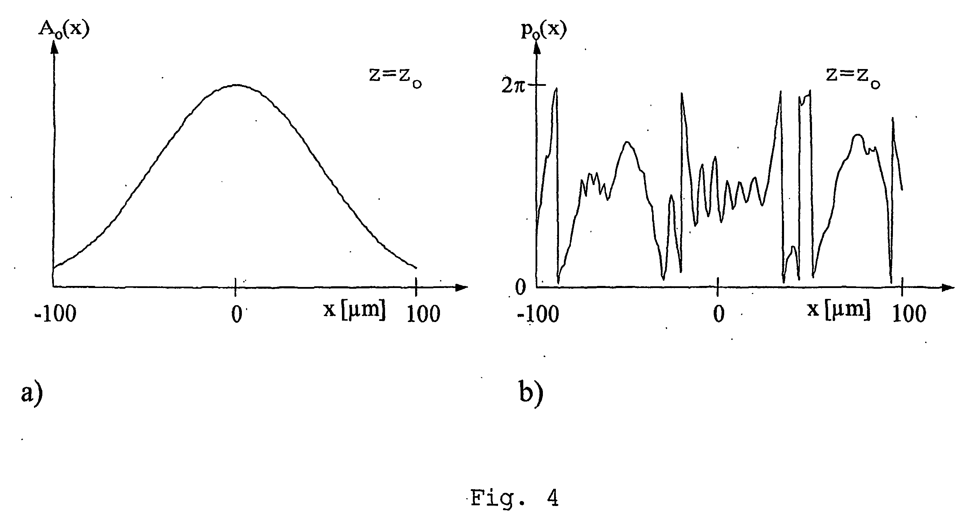

Fig. 4 zeigt die Amplitude und die Phase des bei dem vorliegenden Beispiel gewählten zu verstärkenden Modes an der Stelle $Z_0$ aus Fig. 3, d.h. unmittelbar vor Eintritt in die Phasenstruktur 9.

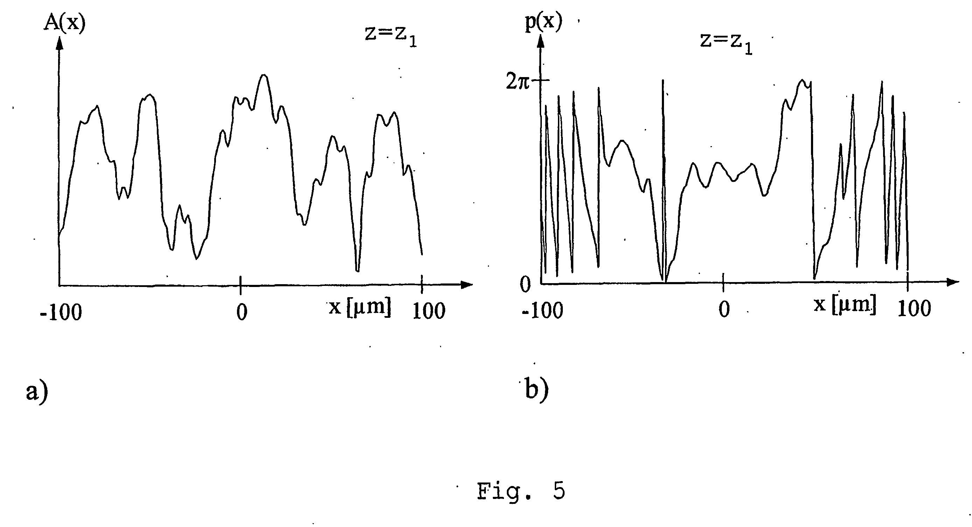

Fig. 5 zeigt die entsprechende Amplitude und Phase des zu verstärkenden Modes bei der Stelle $Z_1$ aus Fig. 3, d.h. unmittelbar vor Eintritt in die Phasenstruktur 8.

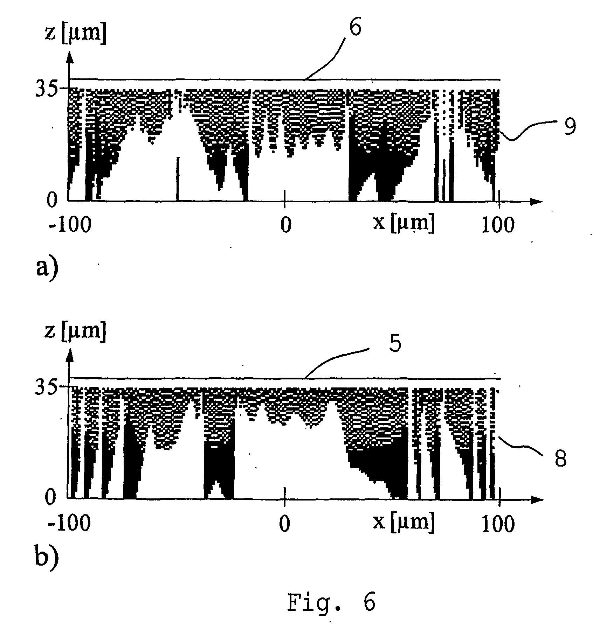

Fig. 6 zeigt die Phasenstrukturen, d.h. die abgedünnten Bereiche in schwarzer Farbe unmittelbar vor der Auskoppelfacette 6 (Fig. 6a) bzw. unmittelbar vor der reflektierenden zweiten Facette 5 (Fig. 6b).

Die folgende Beschreibung eines Beispiels eines Herstellungsverfahrens bezieht sich nun auf diese Fign. 3 bis 6.

Der zu berechnende Laserresonator soll bei einer Wellenlänge $\lambda$ = 1060 nm arbeiten. Das Design startet mit der Vorgabe einer Feldkomponente des zu realisierenden (gewünschten) Fundamentalmodes

$$U(x,z_0) = A_0(x) \exp [i^*p_0(x)]$$

des Resonators 1, d.h. mit der Vorgabe der eindimensionalen lateralen Amplituden und Phasenverteilung $A_0$(x) bzw. $p_0$(x) in der Ebene $z_0$. Dabei wird davon ausgegangen, daß die Dicke der wellenleitenden Schicht so bemessen ist, daß in y-Richtung nur ein lateraler Mode geführt wird, d.h. die y-Abhängigkeit der Feldkomponente U wird nicht berücksichtigt. Im konkreten Beispiel besitzt der gewünschte Fundamentalmode in der Ebene $z_0$ die in Fig. 4a dargestellte Gaußsche Amplitudenverteilung

$$A_0(x) = \exp (- x^2/w^2)$$

mit dem sogenannten Gaußradius w = 65 µm.

Für die Wellenfront oder Phasenverteilung $p_0$(x) wird eine bandbegrenzte Zufallsphase gewählt, d.h. die Phasenwerte variieren statistisch zufällig mit der x-Koordinate, wobei für die auftretenden Ortsfrequenzen $f_x$ der gewählten Phasenfunktion die Relation

$$f_x < f_{max}$$

gelten soll (Bandbegrenzung). Im konkreten Beispiel ist $f_{max}$ = 200 mm$^{-1}$. Fig. 4b zeigt die so berechnete Phasenverteilung oder Wellenfront $p_0$(x) für das hier betrachtete konkrete Beispiel. Die Position $z_0$ wurde im vorliegenden Beispiel so gewählt, daß sie sich auf der Resonatorinnenseite direkt neben der zu berechnenden holographischen Phasenstruktur vor der Auskoppelfacette 6 befindet.

Mit Hilfe von bekannten BPM-Algorithmen (engl.: beampropagation-method, siehe z.B. R. März, Integrated Optics, Artech House Boston 1994) kann die so berechnete Feldverteilung unter Berücksichtigung der geometrischen Wellenleiterparameter durch den lateral nicht strukturierten inneren Bereich 13 des Laserresonators 1 numerisch propagiert werden, wobei man die Feldverteilung $U(x,z_1)$ auf der Resonatorinnenseite direkt vor der zweiten holographischen Phasenstruktur 8, die sich vor der zweiten Resonatorfacette 5 befindet, erhält. Im konkreten Beispiel beträgt die Länge des nichtstrukturierten inneren Resonatorbereiches 13 1,93 mm. Wie Fig. 5 zeigt weicht diese Verteilung in ihrer x-Abhängigkeit sehr stark von der Verteilung $U(x,z_0)$ vor der anderen Phasenstruktur 9 ab, was auf die stark modulierte Phasenverteilung $p_0(x,z_0)$ zurückzuführen ist, die die Ausbreitungseigenschaften des Fundamentalmodes signifikant beeinflußt.

Im nächsten Schritt erfolgt die Berechnung der holographischen Phasenstrukturen 8, 9 vor den beiden Facetten des Resonators. Die optische Funktion dieser Phasenstrukturen 8, 9 besteht darin, daß beim einmaligen Durchgang der Feldverteilungen $U(x,z_0)$ bzw.

$U(x,z_1)$ durch diese Strukturen 9 deren Wellenfront geglättet wird, d.h. daß die Phase des Fundamentalmodes direkt vor den Facetten 5, 6 konstant ist. Die Berechnung der konkreten Form dieser Phasenstrukturen 8, 9 muß unter Berücksichtigung ihrer späteren Realisierung als lokale Abdünnung der Wellenleiterschicht 3 erfolgen. Insbesondere soll die Abdünnung aus Gründen der einfacheren Realisierbarkeit binär erfolgen, d. h. es soll im Bereich dieser Phasenstrukturen 8, 9 nur zwei unterschiedliche Wellenleiterdicken geben. Die Dicke des wellenleitenden Bereiches 3 und das Wellenleitermaterial bestimmen den effektiven Brechungsindex des Wellenleiters 3. Im konkreten Fall ist der effektive Brechungsindex im nicht abgedünnten Bereich $n_{eff}=3,45$, während er im Bereich der Abdünnung $n_{eff}=3.42$ beträgt. Durch eine geeignete Anordnung von Wellenleiterbereichen mit und ohne Abdünnung ist daher eine Beeinflussung der Wellenfrontform der Resonatormoden möglich. Im konkreten Fall erfolgt die Berechnung der abzudünnenden Bereiche (des Phasenelements) durch eine schrittweise Propagätion (z.B. in 100 Schritten) der Feldverteilung $U(x,z_0)$ bzw. $U(x,z_1)$ durch das Phasenelement 8 bzw. 9, wobei nach jedem Schritt an den Stellen x, an denen die Phasenwerte von U kleiner sind als der Durchschnitt aller Phasenwerte, ein abgedünnter Bereich angeordnet wird. In diesen Bereichen erfolgt dementsprechend auf Grund des geringeren effektiven Brechungsindex eine Reduzierung der Wellenfrontabweichung vom Mittelwert. Ist die Ausdehnung dieser Phasenelemente in z-Richtung groß genug, so lässt sich auf diese Weise die Wellenfront von U beim Durchgang durch das Element glätten, bzw. die Phase von U ist vor der Facette 5 bzw. 6 konstant entlang x. Beim zweimaligen Durchgang von U durch das Element 8 bzw. 9 und dazwischenliegender Reflexion an der Facette 5 bzw. 6 wirkt die so berechnete Phasenstruktur 8 bzw. 9 wie ein Phasenkonjugator [3], d.h. aus

$$U(x,z_0) = A_0(x) \exp [i^*p_0(x)]$$

vor der Phasenstruktur wird

$$U(x,z_0) = A_0(x) \exp [-i^*p_0(x)]$$

nach zweimaligem Durchgang und Reflexion an der Facette 5 bzw. 6.

Die Strukturen der abgedünnten Bereiche für das konkrete Designbeispiel sind in den Fign. 6a und 6b dargestellt.

Der abschließende Designschritt umfaßt die Analyse der Umlaufverluste für den Fundamentalmode und die höheren angeregten Moden des nach der beschriebenen Vorschrift berechneten Resonators 1. Diese kann z.B. mit Hilfe des sogenannten Fox-Li-Algorithmus A. Fox, T. Li, "Resonant modes in a maser interferometer," Bell Syst. Techn. J. 40, pp. 453-488, März 1961, erfolgen. Für das konkrete Beispiel erhält man einen Umlaufverlust für den Fundamentalmode von 2,2% und für den zweiten angeregten Mode einen Umlaufverlust von 38%. Die Größe der Umlaufverluste für die höheren Moden werden dabei von der Stärke der Phasenmodulation der vorgegebenen Verteilung $p_0(x)$ bestimmt. Eine genaue Vorhersage der Umlaufverluste für die einzelnen Resonatormoden in Abhängigkeit von der Form der Funktion $p_0(x)$ läßt sich nicht treffen. Generell gilt jedoch, daß bei starker Modulation der Umlaufverlust für die höheren Resonatormoden steigt. Im Design eines konkreten Resonators 1 kann eine Optimierung der Verhältnisse der Umlaufverluste zwischen Fundamentalmode und erstem angeregtem Mode mit Hilfe bekannter Verfahren (z.B. genetische Optimierungsalgorithmen F. Herrera, J.L. Verdegay, Genetic Algorithms and Soft Computing (Studies in Fuzziness and Soft Computing Vol. 8), Physica-Verlag Heidelberg, (1996), erfolgen. Einschränkungen in der realisierbaren Modulationsform ergeben sich aus den herstellbaren lateralen Phasenverteilungen (Abdünnungen des Wellenleiters) und der Gesamtausdehnung des wellenleitenden Bereiches in x-Richtung (Breite des Resonators), da eine Erhöhung der Modulation auch zu einer Verbreiterung der Feldverteilung $U(x,z_1)$ vor der zweiten Facette führt, die natürlich nicht größer sein darf als die Resonatorbreite, um keine zusätzlichen Verluste für den Fundamentalmode einzuführen.

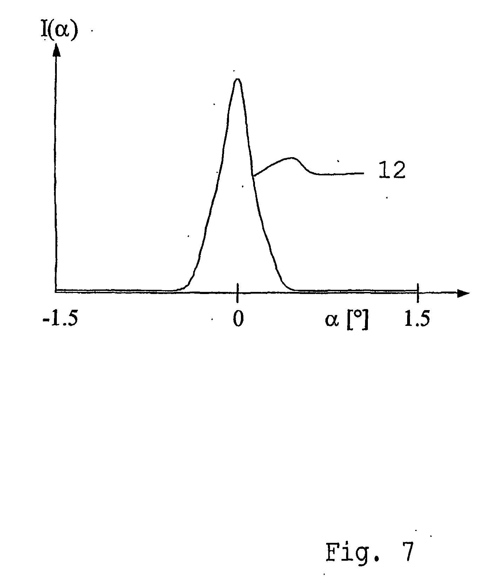

Fig. 7 zeigt die Fernfeldintensitätsverteilung des emittierten Fundamentalmodes des im Beispiel berechneten Resonators, die nur geringfügig von der eines idealen Gaußprofils abweicht.

Zusammenfassend läßt sich feststellen, daß mit Hilfe der erfindungsgemäßen Phasenstrukturen in Halbleiter-Laserresonatoren auch herkömmliche Halbleiter-Laserresonatoren mit großer lateraler Ausdehnung zur Erzielung hoher Laserintensitäten so verändert werden können, daß diese lediglich mit einer gewünschten Zahl in der Wellenleiterebene lateraler Moden, beispielsweise lediglich des Fundamentalmodes, anschwingen, und so monomodige oder gezielt beeinflußt multimodige Laserstrahlen erzeugt werden.

**Patentansprüche**

1. Laserresonator für Halbleiterlaser mit einer Wellenleiterschicht für einen zu verstärkenden Lasermode, der sich zwischen einer Substratschicht und einer Superstratschicht erstreckt und der an zwei in Ausdehnungsrichtung der Wellenleiterschicht gegenüberliegenden Seiten durch eine erste und eine zweite Endfacette als Resonatorendflächen begrenzt ist, wobei die beiden Endfacetten die Ausbreitungsrichtung des zu verstärkenden Lasermodes festlegen.
**dadurch gekennzeichnet,**
**daß**
der Laserresonator zwischen den beiden Endfacetten eine erste, der ersten Endfacette benachbarte und eine zweite, der zweiten Endfacette benachbarte Phasenstruktur aufweist, die derart örtlich in der Ebene der Wellenleiterschicht variieren, daß zumindest ein vorbestimmter in der Ebene der Wellenleiterschicht und senkrecht zu seiner Ausbreitungsrichtung lateraler Lasermode bei Durchgang durch jeweils eine der beiden Phasenstruktur, Reflexion an der benachbarten Endfacette und nochmaligem Durchgang durch dieselbe Phasenstruktur phasenkonjugiert wird, und wobei die Phasenstrukturen derart ausgebildet sind, daß ein vorbestimmter lateraler Lasermode bei Durchgang durch die Phasenstruktur, Reflexion an der benachbarten Endfacette und nochmaligem Durchgang durch dieselbe Phasenstruktur phasenkonjugiert wird, der im Zwischenbereich zwischen der ersten und der zweiten Phasenstruktur eine in der Ebene der Wellenleiterschicht und lateral zur Wellenausbreitungsrichtung stark nichtperiodisch variierende Phasenfront aufweist.

2. Laserresonator nach einem der vorhergehenden Ansprüche, **dadurch gekennzeichnet, daß** zumindest eine Phasenstruktur einen in der Ebene der Wellenleiterschicht zweidimensional variierenden Brechungsindex aufweist.

3. Laserresonator nach dem vorhergehenden Anspruch, **dadurch gekennzeichnet, daß** als Phasenstruktur das Substrat, die Wellenleiterschicht und/oder das Superstrat einen in der Ebene der Wellenleiterschicht zweidimensional variierenden Brechungsindex aufweisen.

4. Laserresonator nach einem der vorhergehenden Ansprüche, **dadurch gekennzeichnet, daß** zumindest eine Phasenstruktur eine in der Ebene der Wellenleiterschicht zweidimensional lokal variierende Dicke der Wellenleiterschicht aufweist.

5. Laserresonator nach dem vorhergehenden Anspruch, **dadurch gekennzeichnet, daß** die Wellenleiterschicht im Bereich der Phasenstrukturen zwei verschiedene Dicken annimmt.

6. Laserresonator nach einem der Ansprüche 2 bis 5, **dadurch gekennzeichnet, daß** für kleine Variationen $\Delta n$ des effektiven Brechungsindex n mit $\Delta n/n < 0,1$ in den besagten Phasenstrukturen die effektive Ausdehnung dieser Phasenstrukturen in Ausbreitungsrichtung des zu verstärkenden Lasermodes größer $\lambda/\Delta n$ ist, wobei $\lambda$ die Wellenlänge der Laserstrahlung in Luft ist.

7. Laserresonator nach einem der vorhergehenden Ansprüche, **dadurch gekennzeichnet, daß** die Wellenleiterschicht weiterhin mindestens eine strahlumlenkende Struktur aufweist, die den in der Wellenleiterschicht umlaufenden Strahl umlenkt.

8. Laserresonator nach dem vorhergehenden Anspruch, **dadurch gekennzeichnet, daß** die strahlumlenkende Struktur ein Spiegel, ein Prisma und/oder ein diffraktives Element ist.

9. Laserresonator nach einem der beiden vorhergehenden Ansprüche, **dadurch gekennzeichnet, daß** die strahlumlenkende Struktur einen tief geätzten Graben, ein Bragg-Gitter mit geraden oder gekrümmten Gitterfurchen, einen prismenförmig gestalteten Bereich des effektiven Brechungsindex und/oder einen total-reflektierenden oder total verspiegelten Bereich aufweist.

10. Laserresonator nach einem der drei vorhergehenden Ansprüche, **dadurch gekennzeichnet, daß** die strahlumlenkende Struktur Teil einer der Endfacetten ist oder zwischen den beiden Phasenstrukturen angeordnet ist.

11. Laserresonator nach einem der Ansprüche 7 bis 10, **dadurch gekennzeichnet, daß** die Wellenleiterschicht als strahlumlenkende Struktur mindestens eine reflektierende Struktur aufweist, die den in der Wellenleiterschicht umlaufenden Strahl ablenkt.

12. Laserresonator nach dem vorhergehenden Anspruch, **dadurch gekennzeichnet, daß** zumindest eine reflektierende Struktur einen Graben mit einer Breite vom Mehrfachen der Wellenlänge des umlaufenden Strahls und hoher effektiver Brechungsindexdifferenz in Totalreflexion zu benachbarten Bereichen aufweist.

13. Laserresonator nach dem vorhergehenden Anspruch, **dadurch gekennzeichnet, daß** die Grabenbreite örtlich variiert.

14. Laserresonator nach einem der drei vorhergehenden Ansprüche, **dadurch gekennzeichnet, daß** zumindest eine reflektierende Struktur ein Bragg-Gitter aufweist, das derart angeordnet ist, daß der umlaufende Strahl unter einem nichtsenkrechten Einfallswinkel auf die Gitterfurchen auftrifft.

15. Laserresonator nach einem der vorhergehenden Ansprüche, **dadurch gekennzeichnet, daß** die Endfacetten plan oder gekrümmt sind.

16. Laserresonator nach einem der vorhergehenden Ansprüche, **dadurch gekennzeichnet, daß** der vorbestimmte Lasermode in der Wellenleiterebene längs der Endfacetten eine konstante Phase aufweist.

17. Laserresonator nach einem der vorhergehenden Ansprüche, **dadurch gekennzeichnet, daß** die Wellenfront des vorbestimmten Lasermodes in der Wellenleiterebene längs der Endfacette dieselbe Krümmung wie die Endfacette aufweist.

18. Laserresonator nach einem der vorhergehenden Ansprüche, **dadurch gekennzeichnet, daß** die Dicke der Wellenleiterschicht so bemessen ist, daß senkrecht zur Ebene der Wellenleiterschicht nur ein lateraler Mode verstärkt wird und auftritt bzw. geführt wird.

19. Laserresonator nach einem der vorhergehenden Ansprüche, **dadurch gekennzeichnet, daß** der Wellenleiterschicht benachbart Streifenelektroden zum Pumpen des Laserresonators derart von der Endfacetten beabstandet angeordnet sind, daß sie die Phasenstrukturen nicht überdecken.

20. Verfahren zur Herstellung eines Laserresonators nach einem der vorhergehenden Ansprüche, **dadurch gekennzeichnet, daß** für den zu verstärkenden vorbestimmten Mode des Laserstrahls an einer Stelle im Bereich zwischen den beiden Phasenstrukturen eine vorbestimmte in der Ebene der Wellenleiterschicht sich erstrekkende eindimensional laterale Amplituden- bzw. Phasenverteilung ($A_0(x)$ bzw. $p_0(x)$) der Wellenfront vorgegeben wird, und die Ausbreitung dieses Modes zwischen den beiden Endfacetten bestimmt wird, wobei die Phasenstrukturen vor den beiden Endfacetten so bestimmt werden, daß die vorbestimmte laterale Phasenverteilung des Modes nach Durchlaufen jeder der Phasenstrukturen in der Wellenleiterebene längs der Endfacetten konstant ist.

21. Verfahren nach dem vorhergehenden Anspruch, **dadurch gekennzeichnet, daß** als vorbestimmte lokale Phasenverteilung des vorbestimmten Modes eine nichtperiodische Phasenverteilung vorgegeben wird.

22. Verfahren nach einem der beiden vorhergehenden Ansprüche, **dadurch gekennzeichnet, daß** als vorbestimmte laterale Phasenverteilung des vorbestimmten Modes eine Zufallsphasenverteilung vorgegeben wird.

23. Verfahren nach einem der drei vorhergehenden Ansprüche, **dadurch gekennzeichnet, daß** als vorbestimmte laterale Phasenverteilung eine in der Wellenleiterebene lateral statistisch variierende Phasenverteilung vorgegeben wird.

24. Verfahren nach einem der Ansprüche 20 bis 23, **dadurch gekennzeichnet, daß** als vorbestimmte laterale Phasenverteilung eine Phasenverteilung mit bandbegrenzten Ortsfrequenzen vorgegeben wird.

25. Verfahren nach einem der Ansprüche 20 bis 24, **dadurch gekennzeichnet, daß** die laterale Modulation der Wellenfront p(x) des elektrischen Feldes des Fundamentalmodes mit der Amplitudenverteilung A (x) in Richtung x senkrecht zur Resonatorachse U (x,z) = A(x)*exp(i*p(x)) im Resonatorquerschnitt der effektiven Brechungsindexverteilung nahe der Lichtaustrittsendfacette des Resonators so vorgegeben wird, daß sie mit einer Funktion p(x) mit mindestens 5 nichtidentischen Wendepunkten beschrieben wird, wobei der minimale Phasenhub zwischen benachbarten Wendepunkten 0.1 π beträgt.

26. Verfahren nach einem der Ansprüche 20 bis 25, **dadurch gekennzeichnet, daß** zur Bestimmung einer der Phasenstrukturen abschnittsweise ausgehend von dem Bereich zwischen den beiden Phasenstrukturen in Ausbreitungsrichtung des Modes in Richtung zu der der Phasenstruktur benachbarten Endfacette folgende Schritte durchgeführt werden:

a) Bestimmen der lateralen Phasenverteilung des vorbestimmten Modes an einer bestimmte Stelle in Ausbreitungsrichtung des Modes und daraus derjenigen Bereiche in lateraler Richtung der Phasenverteilung, in denen die Phase von der durchschnittlichen Phase in vorgegebener Weise abweicht,

b) Vorsehen eines Abschnitts mit verändertem Brechungsindex der Wellenleiterschicht, des Substrats und/oder des Superstrats anschließend an die bestimmte Stelle mit vorbestimmter Ausdehnung in Ausbreitungsrichtung des Modes in denjenigen Bereichen mit abweichender Phase derart, daß beim Durchlaufen des Modes durch einen so bestimmten Bereich mit verändertem Brechungsindex der Abweichung der Phase von der durchschnittlichen Phase entgegengewirkt wird.

c) Berechnung der Ausbreitung des Modes entlang des genannten Abschnitts in Ausbreitungsrichtung des Modes bis zum Ende des genannten Abschnitts,

d) Wiederholen der Schritte a) bis c) für das Ende des Abschnitts als vorbestimmte Stelle bis die in Schritt a) bestimmte Phasenverteilung in lateraler Richtung konstant bzw. gemäß einem vorbestimmten Abbruchkriterium ausreichend konstant ist und

e) Herstellung eines Laserresonators mit der in den Schritten a) bis d) bestimmten Phasenstruktur.

**27.** Verfahren nach dem vorhergehenden Anspruch, **dadurch gekennzeichnet, daß** in Schritt a) diejenigen Bereiche bestimmt werden, in denen die Phase kleiner ist als die durchschnittliche Phase und in Schritt b) die entsprechenden Bereiche mit einem geringeren effektiven Brechungsindex versehen werden.

**28.** Verfahren nach einem der beiden vorhergehenden Ansprüche, **dadurch gekennzeichnet, daß** in Schritt b) die entsprechenden Bereiche als abgedünnte Bereiche ausgebildet werden.

**29.** Verfahren nach einem der drei vorhergehenden Ansprüche, **dadurch gekennzeichnet, daß** für die Bestimmung der Abweichung der Phase in Schritt a) sowie für das Abbruchkriterium in Schritt d) ein gemeinsamer oder zwei verschiedene Schwellwerte vorgesehen sind.

**30.** Verfahren nach einem der Ansprüche 20 bis 29, **dadurch gekennzeichnet, daß** nach der Bestimmung der Phasenstrukturen die Umlaufverluste des vorbestimmten Modes sowie aller weiterer in dem Resonator umlaufender Moden bestimmt werden.

**31.** Verfahren nach einem der Ansprüche 20 bis 30, **dadurch gekennzeichnet, daß** die laterale Phasenverteilung des zu verstärkenden Modes in herkömmlicher Weise, beispielsweise mittels genetischer Optimierungsverfahren optimiert wird, wobei als Optimierungskriterien ein geringer Umlaufverlust des zu verstärkenden Modes, hohe Umlaufverluste der weiteren im Resonator umlaufenden Moden und/oder das Verhältnis dieser Umlaufverluste verwendet werden.

**32.** Verfahren nach einem der Ansprüche 20 bis 31, **dadurch gekennzeichnet, daß** die Ausbreitung des Modes zwischen den Endfacetten mittels einer wellenoptischen Strahlausbreitungsmethode, insbesondere eines BPM-Verfahrens ("beam propagation method", "Strahlfortpflanzungsverfahren") bestimmt wird.

**Claims**

**1.** A laser resonator for semiconductor lasers comprising a waveguide layer for a laser mode to be amplified, which extends between a substrate layer and a superstrate layer and which is limited on two opposite sides in the extension direction of the waveguide layer by a first and a second end facet as resonator end faces, the two end facets determining the propagation direction of the laser mode to be amplified, **characterised in that**

the laser resonator between the two end facets has a first phase structure adjacent to the first end facet and a second phase structure adjacent to the second end facet, which vary locally in the plane of the waveguide layer in such a manner that at least one predetermined lateral laser mode in the plane of the waveguide layer and perpendicular to its propagation direction is phase-conjugated during transmission through each one of the two phase structures, reflection at the adjacent end facet and repeated transmission through the same phase structure, and the phase structures being designed in such a manner that a predetermined lateral laser mode is phase-conjugated during transmission through the phase structure, reflection at the adjacent end facet and repeated transmission through the same phase structure, which mode has, in the intermediate region between the first and the second phase structure, a strongly non-periodically varying phase front in the plane of the waveguide layer and laterally in relation to the wave propagation direction.

**2.** A laser resonator according to one of the preceding claims, **characterised in that** at least one phase structure has a two-dimensionally varying refractive index in the plane of the waveguide layer.

**3.** A laser resonator according to the preceding claim, **characterised in that** the substrate, the waveguide layer and/or the superstrate have as phase structure a two-dimensionally-varying refractive index in the plane of the waveguide layer.

**4.** A laser resonator according to one of the preceding claims, **characterised in that** at least one phase structure has a two-dimensionally locally varying thickness of the waveguide layer in the plane of the waveguide layer.

**5.** A laser resonator according to the preceding claim, **characterised in that** the waveguide layer adopts two different thicknesses in the region of the phase structures.

**6.** A laser resonator according to one of claims 2 to 5, **characterised in that**, for small variations $\Delta n$ of the effective refractive index n with $\Delta n/n < 0.1$ in the said phase structures, the effective extension of these phase structures in the propagation direction of the laser mode to be amplified is greater than $\lambda/\Delta n$, $\lambda$ being the wavelength of the laser radiation in air.

**7.** A laser resonator according to one of the preceding claims, **characterised in that** the waveguide layer also has at least one beam-deflecting structure, which deflects the beam circulating in the waveguide layer.

**8.** A laser resonator according to the preceding claim, **characterised in that** the beam-deflecting structure is a mirror, a prism and/or a diffractive element.

**9.** A laser resonator according to one of the two preceding claims, **characterised in that** the beam-deflecting structure has a deeply etched groove, a Bragg grating with straight or curved grating grooves, a prismatically shaped region of the effective refractive index and/or a totally reflecting or totally mirror-coated region.

**10.** A laser resonator according to one of the three preceding claims, **characterised in that** the beam-deflecting structure is part of one of the end facets or is arranged between the two phase structures.

**11.** A laser resonator according to one of claims 7 to 10, **characterised in that** the waveguide layer has at least one reflecting structure as beam-deflecting structure, which reflecting structure deflects the beam circulating in the waveguide layer.

**12.** A laser resonator according to the preceding claim, **characterised in that** at least one reflecting structure has a groove with a width of the multiple of the wavelength of the circulating beam and a high effective refractive index difference in total reflection in relation to adjacent regions.

**13.** A laser resonator according to the preceding claim, **characterised in that** the groove width varies locally.

**14.** A laser resonator according to one of the three preceding claims, **characterised in that** at least one reflecting structure has a Bragg grating which is arranged in such a manner that the circulating beam impinges on the grating grooves at a non-perpendicular angle of incidence.

**15.** A laser resonator according to one of the preceding claims, **characterised in that** the end facets are plane or curved.

**16.** A laser resonator according to one of the preceding claims, **characterised in that** the predetermined laser mode has a constant phase in the waveguide plane along the end facets.

**17.** A laser resonator according to one of the preceding claims, **characterised in that** the wavefront of the predetermined laser mode in the wave guide plane along the end facet has the same curvature as the end facet.

**18.** A laser resonator according to one of the preceding claims, **characterised in that** the thickness of the waveguide layer is dimensioned such that perpendicularly to the plane of the waveguide layer only one lateral mode is amplified and occurs or is guided.

**19.** A laser resonator according to one of the preceding claims, **characterised in that** strip electrodes adjacent to the waveguide layer for pumping the laser resonator are arranged spaced from the end facets in such a manner that they do not overlap the phase structures.

**20.** A method for producing a laser resonator according to one of the preceding claims, **characterised in that**, for the predetermined mode of the laser beam to be amplified, at one position in the region between the two phase structures, a predetermined one-dimensionally lateral amplitude distribution or phase distribution ($A_o$ (x) or $p_o$ (x)) of the wavefront, which extends in the plane of the waveguide layer, is prescribed, and the propagation of this mode between the two end facets is determined, the phase structures in front of the two end facets being determined such that the predetermined lateral phase distribution of the mode is constant after passing through each of the phase structures in the waveguide plane along the end facets.

**21.** A method according to the preceding claim, **characterised in that** a non-periodic phase distribution is prescribed as predetermined local phase distribution of the predetermined mode.

**22.** A method according to one of the two preceding claims, **characterised in that** a random phase distribution is prescribed as predetermined lateral phase distribution of the predetermined mode.

**23.** A method according to one of the three preceding claims, **characterised in that** a laterally statistically varying phase distribution in the waveguide plane is prescribed as predetermined lateral phase distribution.

**24.** A method according to one of claims 20 to 23, **characterised in that** a phase distribution with band-limited local frequencies is prescribed as predetermined lateral phase distribution.

**25.** A method according to one of claims 20 to 24, **characterised in that** the lateral modulation of the wavefront p (x) of the electrical field of the fundamental mode with the amplitude distribution A (x) in the direction x perpendicular to the resonator axis U (x,z) = A (x) *exp (i*p (x)) in the resonator cross-section of the effective refractive index distribution close to the light exit end facet of the resonator is prescribed such that it is described with a function p (x) with at least five non-identical inflection points, the minimum phase deviation between adjacent inflection points being 0.1 $\pi$.

26. A method according to one of claims 20 to 25, **characterised in that**, in order to determine one of the phase structures by portion starting from the region between the two phase structures in the propagation direction of the mode in the direction towards the end facet adjacent to the phase structure, the following steps are implemented:

a) determination of the lateral phase distribution of the predetermined mode at a specific position in the propagation direction of the mode and therefrom those regions in the lateral direction of the phase distribution in which the phase deviates from the average phase in a prescribed manner,

b) provision of a portion with changed refractive index of the waveguide layer, of the substrate and/or of the superstrate adjacent to the specific position with predetermined extension in the propagation direction of the mode in those regions with a deviating phase in such a manner that during the transmission of the mode through a region determined in this way with changed refractive index, the deviation of the phase from the average phase is counteracted.

c) Calculation of the propagation of the mode along the specified portion in the propagation direction of the mode up to the end of the specified portion,

d) repetition of the steps a) to c) for the end of the portion as predetermined position until the phase distribution determined in step a) in the lateral direction is constant or sufficiently constant according to a predetermined breaking-off criterion, and

e) production of a laser resonator with the phase structure determined in the steps a) to d).

27. A method according to the preceding claim, **characterised in that** in step a) those regions are determined in which the phase is smaller than the average phase, and in step b) the corresponding regions are provided with a lower effective refractive index.

28. A method according to one of the two preceding claims, **characterised in that** in step b) the corresponding regions are formed as thinned regions.

29. A method according to one of the three preceding claims, **characterised in that** a common or two different threshold values are provided for the determination of the deviation of the phase in step a) and also for the breaking-off criterion in step d).

30. A method according to one of claims 20 to 29, **characterised in that** the circulating losses of the predetermined mode and also of all other modes circulating in the resonator are determined after the determination of the phase structures.

31. A method according to one of claims 20 to 30, **characterised in that** the lateral phase distribution of the mode to be amplified is optimised in the conventional manner, for example by means of genetic optimisation methods, a low circulating loss of the mode to be amplified, high circulating losses of the other modes circulating in the resonator and/or the ratio of these circulating losses being used as optimisation criteria.

32. A method according to one of claims 20 to 31, **characterised in that** the propagation of the mode between the end facets is determined by means of a wave-optical beam propagation method, in particular a BPM method ("beam propagation method").

**Revendications**

1. Résonateur de laser pour laser à semi-conducteurs avec une couche guide d'ondes pour un mode laser à amplifier, qui s'étend entre une couche de substrat et une couche de superstrat et qui est limité sur deux côtés opposés dans le sens d'extension de la couche guide d'ondes par une première et une seconde facettes d'extrémité comme surfaces finales de résonateur, les deux facettes d'extrémités définissant le sens de propagation du mode laser à renforcer,
**caractérisé en ce que**
le résonateur de laser présente entre les deux facettes d'extrémité une première structure de phase voisine de la première facette d'extrémité et une seconde structure de phase voisine de la seconde facette d'extrémité, qui varient localement dans le plan de la couche guide d'ondes de telle sorte qu'au moins un mode laser latéral prédéfini, dans le plan de la couche guide d'ondes et perpendiculairement à son sens de propagation est conjugué en phase lors du passage par respectivement l'une des deux structures de phase, de la réflexion sur la facette d'extrémité voisine et du nouveau passage par la même structure de phase, les structures de phase étant conçues de telle sorte qu'un mode de laser latéral prédéfini est conjugué en phase lors du passage par la structure de phase, de la réflexion sur la facette d'extrémité voisine et du nouveau passage par la même structure de phase, qui présente dans la zone intermédiaire entre la première structure de phase et la seconde structure de phase un front de phase variant fortement de façon non périodique dans le plan de la couche guide d'ondes et latéralement par rapport au sens de propagation des ondes.

2. Résonateur de laser selon l'une quelconque des revendications précédentes, **caractérisé en ce qu'**au moins une structure de phase présente un indice de réfraction qui varie en deux dimensions dans le plan de la couche guide d'ondes.

3. Résonateur de laser selon la revendication précédente, **caractérisé en ce que**, en tant que structure de phase, le substrat, la couche guide d'ondes et/ou le superstrat présentent un indice de réfraction qui varie en deux dimensions dans le plan de la couche guide d'ondes.

4. Résonateur de laser selon l'une quelconque des revendications précédentes, **caractérisé en ce qu'**au moins une structure de phase présente une épaisseur de la couche guide d'ondes qui varie localement en deux dimensions dans le plan de la couche guide d'ondes.

5. Résonateur de laser selon la revendication précédente, **caractérisé en ce que** la couche guide d'ondes présente deux épaisseurs différentes dans la zone des structures de phase.

6. Résonateur de laser selon l'une quelconque des revendications 2 à 5, **caractérisé en ce que**, pour de petites variations $\Delta n$ de l'indice de réfraction effectif $n$ avec $\Delta n/n < 0,1$ dans lesdites structures de phase, l'extension effective de ces structures de phase dans le sens de propagation du mode laser à renforcer est supérieure ou égale à $\lambda/\Delta n$, $\lambda$ étant la longueur d'onde du rayonnement laser dans l'air.

7. Résonateur de laser selon l'une quelconque des revendications précédentes, **caractérisé en ce que** la couche guide d'ondes présente toujours au moins une structure déviant le faisceau qui dévie le faisceau tournant dans la couche guide d'ondes.

8. Résonateur de laser selon la revendication précédente, **caractérisé en ce que** la structure déviant le faisceau est un miroir, un prisme et/ou un élément de diffraction.

9. Résonateur de laser selon l'une quelconque des deux revendications précédentes, **caractérisé en ce que** la structure déviant le faisceau présente une tranchée décapée en profondeur, une grille de Bragg avec des rainures de grille droites ou incurvées, une zone conçue en forme de prisme de l'indice de réfraction effectif et/ou une zone à réflexion totale ou complètement argentée.

10. Résonateur de laser selon l'une quelconque des trois revendications précédentes, **caractérisé en ce que** la structure déviant le faisceau fait partie de l'une des facettes d'extrémité ou est disposée entre les deux structures de phase.

11. Résonateur de laser selon l'une quelconque des revendications 7 à 10, **caractérisé en ce que** la couche guide d'ondes présente comme structure déviant le faisceau au moins une structure réfléchissante qui dévie le faisceau circulant dans la couche guide d'ondes.

12. Résonateur de laser selon la revendication précédente, **caractérisé en ce qu'**au moins une structure réfléchissante présente une tranchée avec une largeur égale à plusieurs fois la longueur d'onde du faisceau rotatif et un indice de réfraction effectif élevé avec réflexion totale par rapport aux zones voisines.

13. Résonateur de laser selon la revendication précédente, **caractérisé en ce que** la largeur de la tranchée varie localement.

14. Résonateur de laser selon l'une quelconque des trois revendications précédentes, **caractérisé en ce qu'**au moins une structure réfléchissante présente une grille de Bragg qui est disposée de telle sorte que le faisceau rotatif arrive sur les rainures de la grille en formant un angle d'incidence non perpendiculaire.

15. Résonateur de laser selon l'une quelconque des revendications précédentes, **caractérisé en ce que** les facettes d'extrémité sont planes ou incurvées.

16. Résonateur de laser selon l'une quelconque des revendications précédentes, **caractérisé en ce que** le mode laser prédéfini présente une phase constante dans le plan de guide d'ondes le long des facettes d'extrémité.

17. Résonateur de laser selon l'une quelconque des revendications précédentes, **caractérisé en ce que** le front d'onde du mode laser prédéfini présente, dans le plan du guide d'ondes, le long de la facette d'extrémité, la même courbure que la facette d'extrémité.

18. Résonateur de laser selon l'une quelconque des revendications précédentes, **caractérisé en ce que** l'épaisseur de la couche guide d'ondes est dimensionnée de telle sorte que seul un mode latéral, perpendiculaire au plan de la couche guide d'ondes, est renforcé et apparaît ou est guidé.

19. Résonateur de laser selon l'une quelconque des revendications précédentes, **caractérisé en ce que** des électrodes en bande voisines de la couche guide d'ondes sont disposées à distance des facettes d'extrémité pour le pompage du résonateur de laser de telle sorte qu'elles ne recouvrent pas les structures de phase.

20. Procédé de fabrication d'un résonateur de laser selon l'une quelconque des revendications précédentes,
    **caractérisé en ce que**
    pour le mode prédéfini à renforcer du faisceau laser dans un endroit situé dans la plage entre les deux structures de phase, on prédéfinit une répartition d'amplitude ou de phase ($A_o(x)$ ou $p_o(x)$) du front d'onde qui est latérale dans une dimension, s'étend dans le plan de la couche guide d'ondes et est prédéfinie, et la propagation de ce mode est déterminée entre les deux facettes d'extrémité, les structures de phase avant les deux facettes d'extrémité étant déterminées de telle sorte que la répartition prédéfinie de phase latérale du mode après le passage dans chacune des structures de phase et est constante dans le plan du guide d'ondes le long des facettes d'extrémité.

21. Procédé selon la revendication précédente, **caractérisé en ce qu'**une répartition de phase non périodique est prédéfinie comme répartition prédéterminée de phase locale du mode prédéterminé.

22. Procédé selon l'une quelconque des deux revendications précédentes, **caractérisé en ce qu'**une répartition de phase aléatoire est prédéfinie comme répartition prédéfinie de phase latérale du mode prédéterminé.

23. Procédé selon l'une quelconque des trois revendications précédentes, **caractérisé en ce qu'**une répartition de phase, qui varie sur un plan statistique et latéral dans le plan du guide d'ondes, est prédéfinie comme répartition prédéterminée de phase latérale.

24. Procédé selon l'une quelconque des revendications 20 à 23, **caractérisé en ce qu'**une répartition de phase avec des fréquences locales limitées au niveau de la bande est prédéfinie comme répartition prédéterminée de phase latérale.

25. Procédé selon l'une quelconque des revendications 20 à 24, **caractérisé en ce que** la modulation latérale du front d'onde p(x) du champ électrique du mode fondamental avec la répartition d'amplitude A(x) suivant la direction x perpendiculaire à l'axe du résonateur U(x, z) = A(x)* exp(i*p(x)) dans la section du résonateur de la répartition effective de l'indice de réfraction à proximité de la facette d'extrémité de sortie de lumière du résonateur est prédéfinie de telle sorte qu'elle est décrite avec une fonction p(x) à au moins 5 points d'inflexion non identiques, l'amplitude de déphasage minimale entre les points d'inflexion voisins étant de 0,1 $\pi$.

26. Procédé selon l'une quelconque des revendications 20 à 25, **caractérisé en ce que**, pour déterminer l'une des structures de phase par tranches et en partant de la zone comprise entre les deux structures de phase dans le sens de propagation du mode en direction de la facette d'extrémité voisine de la structure de phase, on applique les étapes suivantes :

    a) détermination de la répartition de phase latérale du mode prédéfini en un endroit défini dans le sens de propagation du mode et, à partir de là, des zones dans la direction latérale de la répartition des phases, dans lesquelles la phase s'écarte de façon prédéfinie de la phase moyenne,
    b) prévision d'une partie avec un indice de réfraction modifié de la couche du guide d'ondes, du substrat et/ou du superstrat à la suite de l'endroit défini avec extension prédéfinie dans le sens de propagation du mode dans les zones avec une phase différente de telle sorte que, lors du passage du mode dans une zone ainsi définie avec un indice de réfraction modifié, on s'oppose à l'écart entre la phase et la phase moyenne,
    c) calcul de la propagation du mode le long de la partie précitée dans le sens de la propagation du mode jusqu'à la fin de la partie précitée,
    d) répétition des étapes a) à c) pour l'extrémité de la partie en tant qu'endroit prédéfini jusqu'à ce que la répartition de phase définie à l'étape a) soit constante dans le sens latéral et suffisamment constante selon un critère d'interruption prédéfini, et
    e) fabrication d'un résonateur de laser avec la structure de phase définie dans les étapes a) à d).

27. Procédé selon la revendication précédente, **caractérisé en ce que**, à l'étape a), on définit les zones dans lesquelles la phase est inférieure à la phase moyenne et, à l'étape b), les zones correspondantes sont accompagnées d'un faible indice de réfraction effectif.

28. Procédé selon l'une quelconque des deux revendications précédentes, **caractérisé en ce que**, à l'étape b), les zones correspondantes sont conçues comme des zones amincies.

29. Procédé selon l'une quelconque des trois revendications précédentes, **caractérisé en ce que**, pour le calcul de l'écart de la phase à l'étape a) et pour le critère d'interruption à l'étape d), on prévoit une valeur seuil commune ou deux valeurs seuils différentes.

30. Procédé selon l'une quelconque des revendications 20 à 29, **caractérisé en ce que**, après la détermination des structures de phase, les pertes par rotation du mode prédéterminé, et de tous les autres modes circulant dans le résonateur sont déterminées.

31. Procédé selon l'une quelconque des revendications 20 à 30, **caractérisé en ce que** la répartition de phase latérale du mode à renforcer est optimisée de façon classique, par exemple au moyen de procédés d'optimisation génétiques, moyennant quoi une faible perte par rotation du mode à amplifier, des pertes par rotation élevées des autres modes circulant dans le résonateur et/ou le rapport de ces pertes par rotation sont utilisées comme critères d'optimisation.

32. Procédé selon l'une quelconque des revendications 20 à 31, **caractérisé en ce que** la propagation du mode entre les facettes d'extrémités est déterminée au moyen d'une méthode de propagation de faisceau d'optique ondulatoire, en particulier un procédé BPM ("beam propagation method", "procédé de propagation du faisceau").

Fig. 1

Fig. 2

Fig. 3

EP 1 295 371 B1

a)

b)

Fig. 4

EP 1 295 371 B1

a)

b)

Fig. 5

EP 1 295 371 B1

Fig. 6

EP 1 295 371 B1

EP 1 295 371 B1

Fig. 7

Fig. 8

EP 1 295 371 B1

Fig. 9

Fig. 10